Europäisches Patentamt

European Patent Office

Office européen des brevets

(19)

(11) Publication number: **0 042 749**

**A1**

(12) **EUROPEAN PATENT APPLICATION**

(21) Application number: **81302794.3**

(22) Date of filing: **22.06.81**

(51) Int. Cl.³: **G 11 C 19/00**
**G 05 B 19/405**

(30) Priority: **24.06.80 JP 85511/80**

(43) Date of publication of application:
**30.12.81 Bulletin 81/52**

(84) Designated Contracting States:
**AT BE CH DE FR GB IT LI LU NL SE**

(71) Applicant: **FUJITSU FANUC LIMITED**
**5-1, Asahigaoka, 3-chome**
**Hino-shi, Tokyo 191(JP)**

(72) Inventor: **Ryoji, Imazeki**
**987-44, Naganuma-cho**
**Hachioji-shi Tokyo(JP)**

(72) Inventor: **Michiya, Inoue**
**5-28-6, Nishihirayama**
**Hino-shi Tokyo(JP)**

(74) Representative: **Billington, Lawrence Emlyn et al,**
**HASELTINE LAKE & CO Hazlitt House 28 Southampton**
**Buildings Chancery Lane**
**London WC2A 1AT(GB)**

(54) **A bubble cassette memory apparatus.**

(57) There is provided a portable bubble cassette memory apparatus which includes a cassette adapter (12) for receiving an inserted cassette-type storage medium (11a, 11b) having a bubble memory element alone or a bubble memory element and a portion of peripheral circuitry. The cassette adapter (12) provides electrical connection to the inserted storage medium (11a, 11b), and houses a control circuit adapted to drive the bubble memory element in accordance with a request signal from a host system (14, 15, 16) and to control information read and write operations with respect to the bubble memory element as well as information transmission between the cassette-type storage medium (11a, 11b) and the host system (14, 15, 16). The cassette adapter (12) is so constructed as to be portable and utilizable commonly by a plurality of host systems (14, 15, 16).

Fig. 1

Croydon Printing Company Ltd.

-1-

A BUBBLE CASSETTE MEMORY APPARATUS

This invention relates to a bubble cassette memory apparatus and, more particularly but not exclusively, to a  bubble cassette memory apparatus adapted for application to a numerical control system to make possible a reduction in the cost of the system.

Numerical control devices (referred to as NC devices hereafter) are adapted to control machine tools on the basis of numerical information prepunched on a paper NC tape, the NC device being equipped with a tape reader that reads in the information.  With the older NC devices the numerical information carried on the NC tape is read in one block at a time, the machine tool being controlled by the NC device in accordance with the instructions in each individual block immediately after that block has been read.  These older NC devices are disadvantageous because the numerical information is read from the tape at a slow speed in a block-by-block fashion, and because partial modification of the information stored on the tape is not possible.

More recent NC devices come equipped with an internal memory for storing the numerical information. With these devices the numerical information carried on the NC tape is read and stored in its entirety in the internal memory before the NC device is used to control the machine tool.  Thus, instead of the old block-by-block control of the machine tool as the information is read from the tape one block at a time, these recent NC devices effect control on the basis of the numerical control information which has already been stored collectively in the internal memory. Nevertheless, these NC devices with the built-in memory still rely upon the conventional paper tape to write the numerical information into the memory, and paper tapes even serve as the storage medium in cases where the numerical information stored in the internal memory is fetched from the memory in one lot and preserved externally of the NC device. Because these tapes are made of paper they have a somewhat limited lifetime and may not be sufficiently reliable when used and stored in the poor environments that are often found in factories where machine tools are installed. Such tapes are difficult to handle as well. Moreover, using paper tapes as the external storage medium mentioned above requires the installation of an expensive paper tape reader and puncher for such purpose.

Attempts at eliminating the shortcomings mentioned above have been made by the introduction of NC devices that rely not upon paper tapes but upon recently developed bubble memories as a non-volatile storage medium.

Bubble memories are magnetically driven and therefore may require a considerable amount of expensive equipment to enable a bubble memory element to be used as a storage medium in place of a paper tape. Such equipment may include a driver for driving a coil located within the bubble memory element and for driving a variety of gates, a sense amplifier for reading outputs, and a control circuit for producing the signals that drive the coil and gates. The driver and sense amplifier may constitute peripheral circuitry.

According to the invention there is provided a bubble cassette memory apparatus which is cooperable with a host system, the apparatus comprising a cassette adapter which can receive a cassette-type storage medium comprising a bubble memory element and which is adapted for electrical connection to the bubble memory element of such cassette-type storage medium when the latter is received in the cassette adapter, the cassette adapter comprising control circuitry adapted to drive said bubble memory element in accordance with a request signal from a host system when the apparatus is in use, and to control information read and write operations with respect to said bubble memory element and information transmission between said cassette-type storage medium and said host system when the apparatus is in use, the cassette adapter being portable.

An embodiment of the present invention may allow a bubble memory cassette adapter to be deleted from an NC device or from the control panel of a machine tool in an NC system that employs a bubble memory as a storage medium. An embodiment of the present invention may provide a novel apparatus that allows a single bubble memory cassette adapter to be employed by a plurality of NC devices in an NC system that uses a bubble memory as a storage medium.

Features and advantages of embodiments of the invention will be apparent from the following description taken in connection with the accompanying drawings, by way of example, wherein:

Figure 1 is an illustrative view which is useful in describing an embodiment of a portable bubble cassette memory apparatus according to the present invention; and

Figure 2 and Figure 3 are respectively illustrative views which are useful in describing other embodiments of a portable bubble cassette memory apparatus according to the present invention.

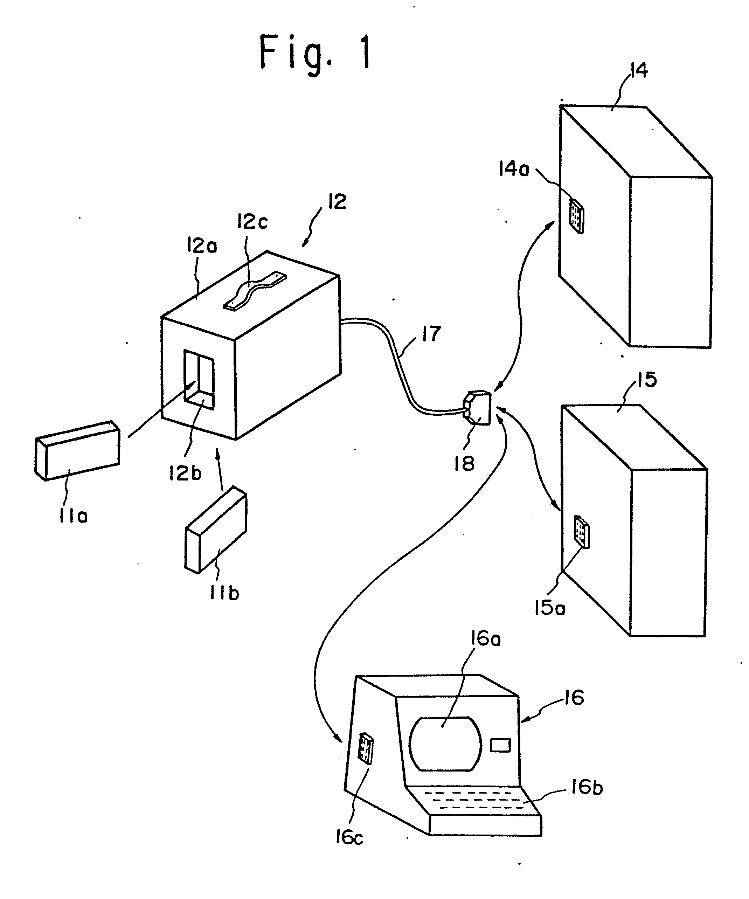

In the Figure 1, numerals 11a, 11b each denote a cassette-type storage medium (referred to as a bubble cassette hereafter) having a bubble memory element alone or a bubble memory element and a portion of the peripheral circuitry. A cassette adapter 12 has a casing 12a which accommodates a control circuit and all or a part of the peripheral circuitry, and which is formed to include a cassette holder 12b for retaining whichever of the bubble cassettes 11a, 11b has been inserted therein, and for providing electrical connection to the housed peripheral circuitry and control circuit. The casing 12 is small in size and is provided at its top with a handle 12c for easy carrying, so that the entire cassette adapter 12 is portable. Numerical control devices (NC devices) are indicated at numerals 14, 15. The NC devices include a built-in memory for storing a part program, as well as receptacles 14a, 15a, respectively, which are installed in the casing to make possible an electrical connection between the NC device and the cassette adapter 12 via a cable and plug mentioned below. A programming apparatus 16, for the purpose of writing a part program into the bubble cassettes 11a, 11b, includes a display section 16a and a keyboard 16b, as well as a receptable 16c which is installed in the casing to make possible an electrical connection between the programming apparatus and the cassette adapter 12 through the cable and plug. The cable, denoted by numeral 17, has one end thereof connected directly to the circuitry housed within the cassette adapter 12, and has the other end thereof connected to a plug 18 which is adapted to be plugged into any of the receptables 14a, 15a, 16c. Thus, the cable 17 and plug 18 enable, in dependence upon the control circuit in the cassette adapter 12, an exchange of signals and information between the peripheral circuitry and control circuit housed within the cassette adapter 12, on the one hand, and either the NC devices 14, 15 or programming apparatus 16
on the other, and permit a part program to be read from or
written into either of thebubble cassettes 11a,
11b.  The cable 17 and plug 18 also enable
the bubble memory element to be driven by
the control circuit in the adapter 12 in accordance
with a request signal from the host system.

In operation, assume that the NC device 14 is to execute numerically controlled machining using a part program which has been stored in the bubble cassette 11a. In this case the bubble cassette 11a is inserted into the cassette holder 12b of the cassette adapter 12, and the plug 18 is plugged into the receptacle 14a of the NC device 14 to establish an electrical connection between the bubble cassette 11a and the NC device 14 through the cassette adapter 12. Once this connection has been made the part program stored in the bubble cassette 11a is transferred to and stored in the memory that is built-in the NC device 14. The NC device 14 then executes a numerical control operation on the basis of the part program. Similarly, if the NC device 15 is to execute numerically controlled machining using the part program stored in the bubble cassette 11a, the plug 18 is plugged into the receptacle 15a to transfer and store the program in the NC device 15 as described above. Further, a numerically controlled machining operation on the basis of a part program stored in the bubble cassette 11b can be carried out merely by inserting the bubble cassette 11b into the cassette holder 12b.

Thus, any desired numerically controlled machining operation can be carried out by exchanging the bubble cassette inserted into the cassette holder 12b, and any desired NC device can be made to execute the operation merely by connecting the cassette adapter 12 into that NC device.

To write a part program created by the programming apparatus 16 into the bubble memory of, say, the bubble cassette 11a, the plug 18 need only be plugged into the receptacle 16c to establish an electrical connection between the bubble cassette 11a and programming apparatus 16 through the cassette adapter 12. The programming apparatus 16, it should be noted, has a built-in interface circuit.

Only one cassette adapter need be provided for a plurality of NC devices, so that the system cost can be reduced. In general a programming apparatus is required for the purpose of writing a part program into the memory of a bubble cassette. With the present embodiments this is made possible through the intermediary of the cassette adapter merely by providing the programming apparatus with the interface circuit.

If the interface between the portable cassette adapter and NC device is a standard one such as an EIA-232-C interface, hardware costs can be reduced since it would be possible to employ interface circuitry common with that of other input/output machines, such as paper tape readers, paper tape punchers and tele-typewriters.

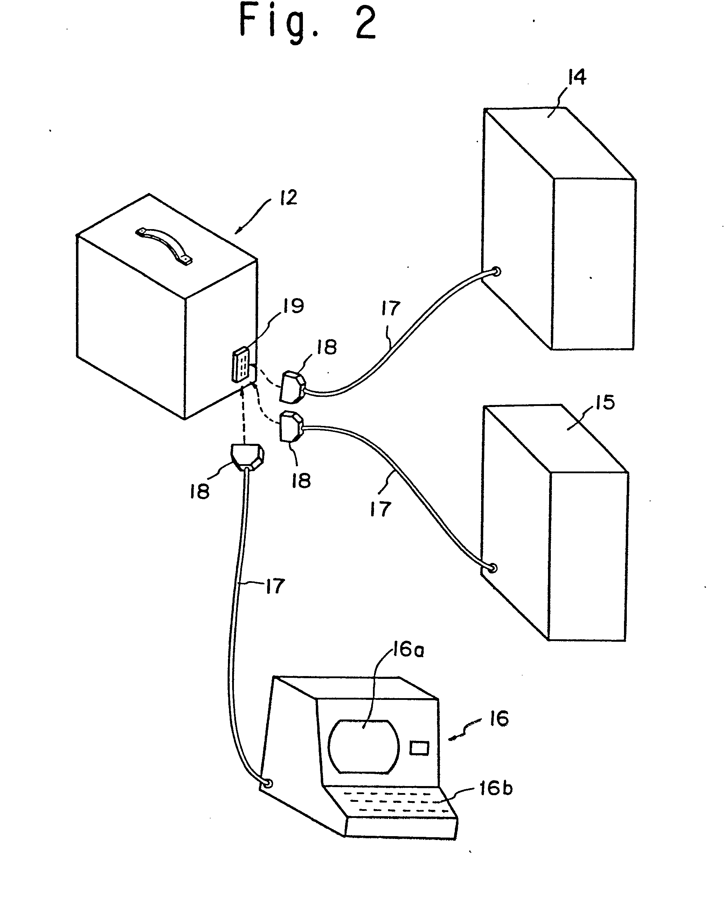

In the illustrated Figure 1 embodiment the cable 17 with the attached plug 18 is provided on the cassette adapter 12, and a receptacle for receiving the plug 18 is provided on each of the NC devices 14, 15 and on the programming apparatus 16. In an alternative arrangement as shown in Figure 2, a cable 17 with an attached plug 18 can be provided on each of the NC devices 14, 15 and on the programming apparatus 16, in which case a receptacle 19 for receiving the plug 18 would be provided on the cassette adapter 12.

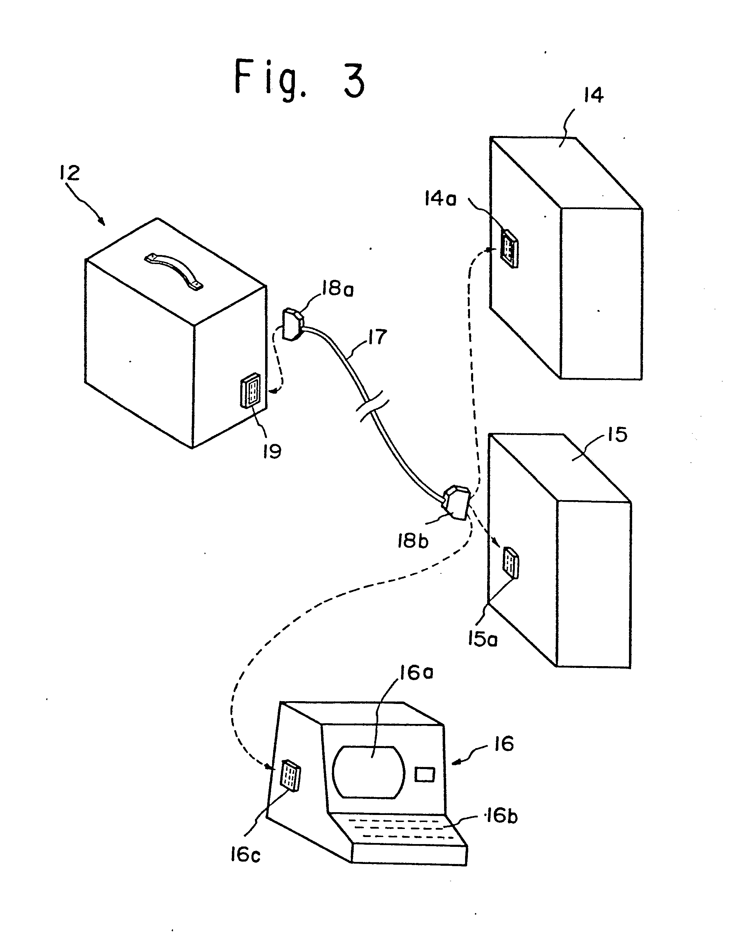

In a further alternative arrangement as shown in Figure 3, a receptacle 14a, 15a, 16c, 19 for receiving a plug is provided respectively on the NC devices 14, 15, on the programming apparatus 16, and on the cassette adapter 12, and a plug 18a, 18b is respectively attached at each end of the cable 17, wherein the plug 18a is received by the receptacle 19 provided on the cassette adapter 12 and the plug 18b is received by one of the receptacles 14a, 15a, 16c which is desired.

The described and illustrated portable bubble cassette memory apparatus comprises a bubble memory cassette containing a bubble memory element alone or a bubble memory element and a portion of the peripheral circuitry, and a cassette adapter which contains all or a portion of the peripheral circuitry, the control circuit and a holder for holding the inserted bubble memory cassette and for establishing electrical contact with the bubble memory element of the cassette, possibly via its peripheral circuitry. The cassette adapter responds to commands from the NC device proper to read information from the bubble memory cassette and to write information into memory.

There is provided a portable bubble cassette memory apparatus which includes a cassette adapter (12) for receiving an inserted cassette-type storage medium (11a, 11b) having a bubble memory element alone or a bubble memory element and a portion of peripheral circuitry. The cassette adapter (12) provides electrical connection to the inserted storage medium (11a, 11b), and houses a control circuit adapted to drive the bubble memory element in accordance with a request signal from a host system (14, 15, 16) and to control information read and write operations with respect to the bubble memory element as well as information transmission between the cassette-type storage medium (11a, 11b) and the host system (14, 15, 16). The cassette adapter (12) is so constructed as to be portable and utilizable commonly by a plurality of host systems (14, 15, 16).

As many apparently widely different embodiments of this invention may be made without departing from the spirit and scope thereof, it is to be understood that the invention is not limited to the specific embodiments thereof except as defined in the appended claims.

CLAIMS

1.    A bubble cassette memory apparatus which is co-operable with a host system, the apparatus comprising a cassette adapter which can receive a cassette-type storage medium comprising a  bubble memory element and which is adapted for electrical connection to the bubble memory element of such cassette-type storage medium when the latter is received in the cassette adapter, the cassette adapter comprising control circuitry adapted to drive said bubble memory element in accordance with a request signal from a host system when the apparatus is in use, and to control information read and write operations with respect to said bubble memory element and information transmission between said cassette-type storage medium and said host system when the apparatus is in use, the cassette adapter being portable.

2.    A bubble cassette memory apparatus according to claim 1, wherein the cassette adapter can receive a cassette-type storage medium comprising a portion of peripheral circuitry in addition to a bubble memory element, and is adapted for electrical connection to said portion of peripheral circuitry.

3.    A bubble cassette memory apparatus according to claim 1 or 2, when comprising a cassette-type storage medium comprising a bubble memory element.

4.    A bubble cassette memory apparatus according to claim 3, wherein the cassette-type storage medium comprises a portion of peripheral circuitry.

5.    A bubble cassette memory apparatus according to any preceding claim, wherein the cassette adapter is suitable for use with a plurality of different host systems and comprises a cable with a plug at one end for connection to a host system.

6.    A bubble cassette memory apparatus according to any of claims 1 to 4, wherein the cassette adapter is suitable for use with a plurality of different host systems and comprises a receptacle for a plug connected by a cable to a host system.

7. A bubble cassette memory apparatus according to claim 6, comprising a cable with a plug at each end for connecting the cassette adapter to a host system.

8. A bubble cassette memory apparatus according to any preceding claim, which is adapted for co-operation with a numerical control device as a host system.

9. A bubble cassette memory apparatus according to any preceding claim, which is adapted for co-operation with a programming apparatus as a host system.

10. A bubble cassette memory apparatus according to any preceding claim, when in operable combination with a host system.

0042749

Fig. 1

# Fig. 2

0042749

# Fig. 3

# 0042749

European Patent Office

## EUROPEAN SEARCH REPORT

Application number

EP 81 30 2794

## DOCUMENTS CONSIDERED TO BE RELEVANT

| Category | Citation of document with indication, where appropriate, of relevant passages | Relevant to claim |
|---|---|---|
| | INSTITUTE OF ELECTRICAL AND ELECTRONICS ENGINEERS, Computer Society International Conference. Spring Conference (Digest of papers from Compcon), 28th February - 3rd March 1977, pages 258-262 New York, U.S.A. F.J. BECKER et al.: "Packaging of a large capacity magnetic bubble domain spacecraft recorder"<br><br>* Page 260, left-hand column, line 11 - page 261, right-hand column, line 44; figures on pages 258,260,261 *<br><br>-- | 1-4,8, 10 |
| | FR - B - 2 172 675 (SAAB-SCANIA)<br><br>* Page 2, line 35 - page 4, line 33; figures 1,2 *<br><br>-- | 1,5,10 |
| | FR - A - 2 356 985 (FUJITSU FANUC LTD.)<br><br>* Page 3, line 25 - page 7, line 34; figures 1-4 *<br><br>---- | 1 |

### CLASSIFICATION OF THE APPLICATION (Int Cl.3)

G 11 C 19/00
G 05 B 19/405

### TECHNICAL FIELDS SEARCHED (Int. Cl.3)

G 11 C 19/00
G 05 B 19/405

### CATEGORY OF CITED DOCUMENTS

X: particularly relevant
A: technological background
O: non-written disclosure
P: intermediate document
T: theory or principle underlying the invention
E: conflicting application
D: document cited in the application
L: citation for other reasons

&: member of the same patent family
corresponding document

The present search report has been drawn up for all claims

| Place of search | Date of completion of the search | Examiner |
|---|---|---|
| The Hague | 07-10-1981 | DEGRAEVE |

EPO Form 1503 1  06.78